# EUROPÄISCHE PATENTSCHRIFT

(11) **EP 2 766 743 B1**
(45) Veröffentlichungstag und Bekanntmachung des Hinweises auf die Patenterteilung: **04.11.2015**
(21) Anmeldenummer: 12769991.6
(22) Anmeldetag: 12.09.2012
(51) Int. Cl.: G01S 7/03, G01F 23/284, G01S 13/88, H03D 7/14, G01S 13/10

(54) **SCHALTUNGSANORDNUNG**
CIRCUIT ASSEMBLY
ENSEMBLE DE CIRCUITS

(30) Priorität: 12.10.2011 DE 102011084355
(43) Veröffentlichungstag der Anmeldung: 20.08.2014
(73) Patentinhaber: Endress+Hauser GmbH+Co. KG, 79689 Maulburg (DE)
(72) Erfinder: MICHALSKI, Bernhard, 79689 Maulburg (DE)
(74) Vertreter: Andres, Angelika Maria
(86) Internationale Anmeldenummer: PCT/EP2012/067795
(87) Internationale Veröffentlichungsnummer: WO 2013/053558

(56) Entgegenhaltungen:
- EP-A1- 0 955 527
- EP-B1- 2 045 617
- WO-A1-2010/021709
- GB-A- 2 094 091
- US-A- 3 585 634
- US-A1- 2008 088 179
- US-B1- 8 026 760
- "DC-to-2.5 GHz Active Mixer AD8343", , 1. November 2006 (2006-11-01), XP055044475, Gefunden im Internet: URL:http://www.analog.com/static/imported- files/data_sheets/AD8343.pdf [gefunden am 2012-11-16]

## Beschreibung

Die Erfindung betrifft eine Schaltungsanordnung zur Umsetzung von einem differenziellen Signalpfad am Ausgang eines Mischers auf einen gegen Bezugspotential geschalteten Signalpfad. Weiterhin betrifft die Erfindung ein Pulsradargerät, bei dem die Schaltungsanordnung zum Einsatz kommt.

Bekannte Radarmessgeräte zur Bestimmung des Füllstands eines Füllguts in einem Behälter arbeiten nach dem Laufzeitdifferenzverfahren. Laufzeitdifferenzverfahren nutzen die physikalische Gesetzmäßigkeit aus, wonach die Laufstrecke gleich dem Produkt aus Laufzeit und Ausbreitungsgeschwindigkeit ist. Im Falle der Füllstandsmessung entspricht die Laufstrecke dem doppelten Abstand zwischen Antenne und Oberfläche des Füllguts. Das Echosignal, also das an der Oberfläche des Füllguts reflektierte Signal, und dessen Laufzeit werden anhand der sog. Echofunktion bzw. der digitalisierten Hüllkurve bzw. der Zwischenfrequenzkurve bestimmt, wobei diese die Amplituden der Echosignale als Funktion des Abstandes 'Antenne-Oberfläche des Füllguts' wiedergibt. Der Füllstand selbst lässt sich dann aus der Differenz zwischen dem bekannten Abstand der Antenne zum Boden des Behälters und dem durch die Messung bestimmten Abstand der Oberfläche des Füllguts zur Antenne ermitteln. Mikrowellenmessgeräte, die Pulsradar verwenden, werden von der Anmelderin unter der Bezeichnung 'MICROPILOT' vertrieben.

Aus der EP 2 045617 B1 ist ein Pulsradargerät zur Bestimmung oder Überwachung des Füllstands eines Füllguts in einem Behälter bekannt geworden. Ein Sendetaktgenerator erzeugt einen Sendetakt mit einer vorgegebenen Sendetaktfrequenz. Ein Sendepulsgenerator, der von dem Sendetakt getriggert wird, leitet Sendepulse mit der Sendetaktfrequenz an eine Antenne weiter. Die Antenne strahlt die Sendepulse in Richtung der Oberfläche des Füllguts ab und empfängt die an der Oberfläche des Füllguts reflektierten Echosignale. Die Echosignale werden mit einer Abtasttaktfrequenz abgetastet, die sich geringfügig von der Sendetaktfrequenz unterscheidet. Ein Abtastpulsgenerator, der von dem Abtasttakt getriggert wird, erzeugt die Abtastpulse mit der Abtasttaktfrequenz. Zwecks Erzeugung eines Zwischenfrequenzsignals werden die Echopulse mit den Sendepulsen in einem Mischer gemischt. Über einen Integrier wird das Zwischenfrequenzsignal integriert. Der Integrierer umfasst eine Abtast-/Halteschaltung, die einen Schalter und einen Kondensator aufweist. Der Schalter ist so ausgelegt, dass das Zwischenfrequenzsignal mit der Abtasttaktfrequenz abgetastet wird. Die bekannte Schaltungsanordnung ist auf einem Halbleiterchip kaum realisierbar.

Der Erfindung liegt die Aufgabe zugrunde, eine Schaltungsanordnung zur Umsetzung von einem differenziellen Signalpfad am Ausgang eines Mischers auf einen gegen Bezugspotential geschalteten Signalpfad vorzuschlagen, die in einfacher Weise auf einem Halbleiterchip realisierbar ist.

Die Aufgabe wird durch eine Schaltungsanordnung mit den folgenden Merkmalen gelöst:
- in jedem der beiden Einzelsignalpfade des differentiellen Signalpfades ist jeweils ein steuerbares Schaltelement vorgesehen;
- in Reihe zu den beiden Schaltelementen ist ein erstes Speicherelement geschaltet;
- es ist zumindest eine Steuerung für die beiden Schaltelemente vorgesehen, die während einer Aufladephase des ersten Speicherelements den differentiellen Signalpfad am Ausgang des Mischers mit dem ersten Speicherelement verbindet und das am differentiellen Ausgang des Mischers anliegende Ausgangssignal auf das erste Speicherelement lädt, und die während der Entlade- bzw. Umladephase das erste Speicherelement mit dem gegen das Bezugspotential geschalteten Signalpfad verbindet, so dass die im ersten Speicherelement gespeicherte Ladung über den gegen das Bezugspotential geschalteten Signalpfad umgeladen wird.

Zusammengefasst gesagt, beschreibt die erfindungsgemäße Lösung die Umsetzung eines differentiellen Signals am Ausgang eines Mischers auf eine Single-ended Schaltung mit einer Schalter-Kondensator-Konfiguration. Der wesentliche Vorteil der erfindungsgemäßen Schaltungsanordnung ist darin zu sehen, dass sie sich mit minimalem Schaltungsaufwand einfach und kostengünstig auf einem Halbleiter-Chip realisieren lässt. Bevorzugt handelt es sich bei den in Verbindung mit der Erfindung verwendeten Speicherelementen um Kondensatoren. Bei dem Bezugspotential handelt es sich bevorzugt um das Massepotential.

Gemäß einer bevorzugten Ausgestaltung der erfindungsgemäßen Schaltungsanordnung ist parallel zu dem ersten Speicherelement ein zweites Speicherelement vorgesehen, das mit einem Ausgang gegen das Bezugspotential geschaltet ist, so dass während der Entlade- bzw. Umladephase die im ersten Speicherelement gespeicherte Ladung auf das zweite Speicherelement umgeladen wird.

Eine vorteilhafte Weiterbildung der erfindungsgemäßen Schaltungsanordnung schlägt vor, dass der Mischer mit dem differenziellen Signalpfad, die beiden Schaltelemente und das erste Speicherelement auf einem Halbleiter-Chip angeordnet sind. Alternativ wird vorgeschlagen, dass der Mischer mit dem differenziellen Signalpfad auf einem Halbleiter-Chip angeordnet ist.

Bevorzugt kommt die erfindungsgemäße Schaltungsanordnung in Verbindung mit einem Pulsradargerät zur Bestimmung oder Überwachung des Füllstands eines Füllguts in einem Behälter zum Einsatz. Das Pulsradargerät umfasst die folgenden Komponenten:
- einen Sendetaktgenerator zum Erzeugen eines Sendetakts mit einer vorgegebenen Sendetaktfrequenz,
- einen Sendepulsgenerator, der von dem Sendetakt getriggert wird, um Sendepulse mit der Sendetaktfrequenz an eine Antenne weiterzuleiten,
- die Antenne, die Sendepulse in Richtung der Oberfläche des Füllguts abstrahlt und die an der Oberfläche des Füllguts reflektierten Echosignale empfängt,
- einen Abtasttaktgenerator zum Erzeugen eines Abtasttakts mit einer vorgegebenen Abtasttaktfrequenz, die sich geringfügig von der Sendetaktfrequenz unterscheidet,
- einen Abtastpulsgenerator, der von dem Abtasttakt getriggert wird, um Abtastpulse mit der Abtasttaktfrequenz zu erzeugen,
- einen Mischer zum Erzeugen eines Zwischenfrequenzsignals durch Mischen der Echopulse mit den Sendepulsen,
- ein Integrierglied zur Integration des Zwischenfrequenzsignals, wobei das Integrierglied die erfindungsgemäße Schaltungsanordnung zur Umsetzung von zwei differenziellen Signalpfaden am Ausgang des Mischers auf einen gegen Bezugspotential geschalteten Signalpfad umfasst. Wie bereits erwähnt, handelt es sich bei dem Bezugspotential bevorzugt um das Massepotential. Die Speicherelemente sind bevorzugt als Kondensatoren ausgebildet.

Als besonders vorteilhaft wird es in Verbindung mit der Erfindung angesehen, wenn die Steuerung und die beiden Schaltelemente so ausgelegt sind, dass das Zwischenfrequenzsignal mit der Abtasttaktfrequenz abgetastet wird.

Entweder ist die Steuerung in diesem Zusammenhang so ausgelegt ist, dass sie die beiden Schaltelemente simultan steuert. Alternativ besteht auch die Möglichkeit, zwei separate Steuerungen vorzusehen, die die beiden Schaltelemente simultan steuern. Bei den Schaltelementen handelt es sich bevorzugt um elektronische Schalter. Beispielsweise sind die elektronischen Schalter aus CMOS Transistoren aufgebaut.

Die Erfindung wird anhand der nachfolgenden Figuren näher erläutert. Es zeigt:
Fig. 1: eine schematische Darstellung eines Pulsradargeräts, bei dem die erfindungsgemäße Schaltungsanordnung zum Einsatz kommt,
Fig. 2: eine schematische Darstellung einer Ausgestaltung der erfindungsgemäßen Schaltungsanordnung und
Fig. 3: eine Ausgestaltung der erfindungsgemäßen Schaltungsanordnung.

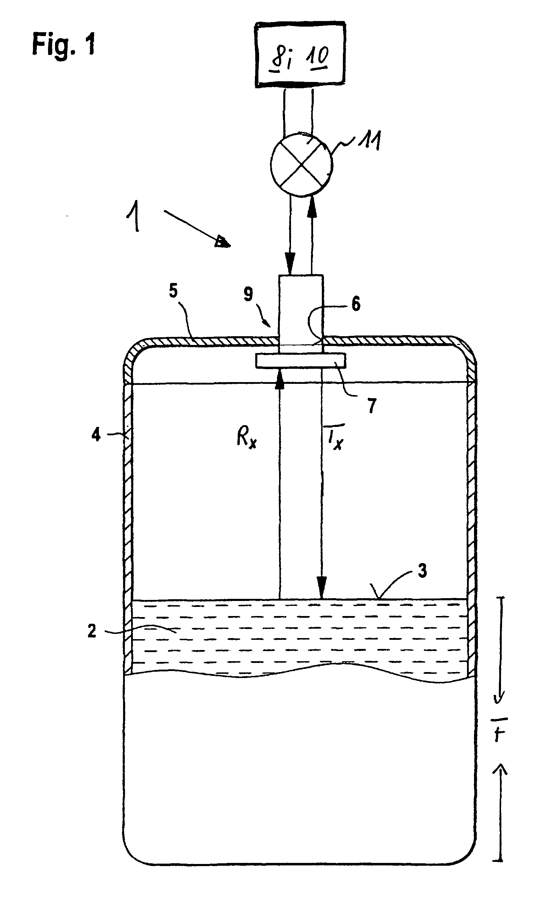

Fig. 1 zeigt eine schematische Darstellung einer Ausgestaltung eines an einem Behälter 4 angeordneten Pulsradargeräts 1, bei dem die erfindungsgemäße Schaltungsanordnung 12 bevorzugt zum Einsatz kommt. Ein Füllgut 2 ist in einem Behälter 4 gelagert. Zur Bestimmung des Füllstandes F dient das Pulsradargerät 1, das in einer Öffnung 6 im Deckel 5 des Behälters 4 montiert ist. Über die Antenne 7 werden die in der Signalerzeugungseinheit 8 erzeugten hochfrequenten Sendepulse Tx in Richtung der Oberfläche 3 des Füllguts 2 abgestrahlt. An der Oberfläche 3 werden die Sendepulse teilweise als Echopulse Rx reflektiert. Diese Echopulse Rx werden in der Empfangs-/Auswerteeinheit 10 empfangen und über ein Laufzeitdifferenzverfahrens ausgewertet. Die korrekte Taktung von Absendung der Messpulse Tx und Empfang der Echopulse Rx erfolgt über die Sende-Empfangsweiche 11.

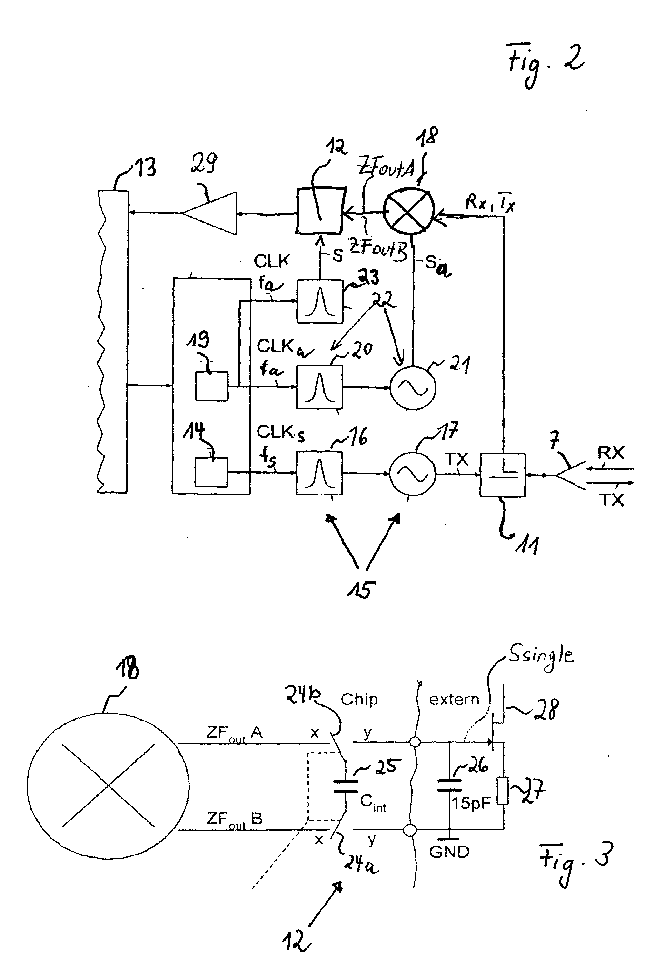

Fig. 2 zeigt eine schematische Darstellung einer Ausgestaltung eines Pulsradargeräts 1, bei dem die erfindungsgemäße Schaltungsanordnung 12 verwendet wird. Wichtige Komponenten eines Pulsradargeräts 1 sind die Signalerzeugungseinheit 8 und die Empfangs-/Auswerteschaltung 10.

Unter der Kontrolle eines Mikrocontrollers 13 erzeugt der Sendetaktgenerator 14 den Sendetakt CLKs mit einer vorgegebenen Sendetaktfrequenz fs. Die Sendetaktfrequenz fs liegt im MHz-Bereich. Der Sendepulsgenerator 15, der aus einem Pulsformer 16 und einem Sendeoszillator 17 besteht, wird vom Sendetakt CLKs getriggert und leitet die Sendepulse Tx mit der Sendetaktfrequenz fs an die Antenne 7 weiter. Die Antenne 7 strahlt die Sendepulse Tx in Richtung der Oberfläche 3 des Füllguts 2 ab; üblicherweise empfängt sie auch die an der Oberfläche 3 des Füllguts 2 reflektierten Echopulse Rx. Es versteht sich von selbst, dass Sende- und Empfangsantenne auch als separate Einheiten ausgestaltet sein können. Die Dauer der Sendepulse Tx liegt im ns-Bereich. Eine typische Frequenz für die Sendepulse Tx bei Pulsradargeräten der Anmelderin liegt bei 26 GHz. Das Aussenden der Sendepulse Tx und das Empfangen der Echopulse Rx erfolgt über die Sende-/Empfangsweiche 11 und die Antenne 7.

Die Echopulse Rx werden einem Mischer 18 zugeführt. Ein Abtasttaktgenerator 19 erzeugt einen Abtasttakt CLKa mit einer vorgegebenen Abtasttaktfrequenz fa, die sich geringfügig von der Sendetaktfrequenz fs unterscheidet. Der Abtastpulsgenerator 22 weist einen Pulsformer 20 und einen Oszillator 21 auf. Der Abtastpulsgenerator 22 wird von dem Abtasttakt CLKa getriggert, und es werden Abtastpulse Sa mit der Abtasttaktfrequenz fa erzeugt. Die Abtastpulse Sa haben die gleiche Pulsform wie die Sendepulse Tx.

Der Mischer 18 erzeugt durch Mischen der Echopulse Rx mit den Sendepulsen Tx bzw. Sa ein Zwischenfrequenzsignal ZF. Das Zwischenfrequenzsignal Zf wird einem Integrierglied 12 zugeführt, das der erfindungsgemäßen Schaltungsanordnung 12 entspricht. Über den Steuerpulsgenerator 23 werden Steuerpulse S erzeugt, die dem Integrierglied 12 zugeführt werden. Mit den Steuerpulsen S werden die Schaltelemente 24 der erfindungsgemäßen Schaltungsanordnung 12 mit der Abtasttaktfrequenz fa und mit einer einstellbaren Zeitverzögerung auf die Sendepulse Tx gesteuert. Das Ausgangssignal des Integriergliedes 12 wird einem Verstärker 29 zugeführt. Aus dem am Ausgang des Verstärkers 29 anstehenden verstärkten Signal wird anhand der Laufzeitdifferenz von Sendepulsen Tx und Echopulsen Rx in dem Mikrocontroller 10 der Füllstand F des Füllguts 2 in dem Behälter 2 ermittelt.

Fig. 3 zeigt eine bevorzugte Ausgestaltung der erfindungsgemäßen Schaltungsanordnung 12, bei der es sich um eine Abtast-/Halteschaltung handelt. Die erfindungsgemäße Schaltungsanordnung 12 ist so ausgestaltet, dass sie den differenziellen Signalpfad *ZFₒᵤₜ* A - *ZFₒᵤₜ* B am Ausgang des Mischers 18 auf einen gegen Bezugspotential GND geschalteten Signalpfad *S*_{sin*gle*} umsetzt. Der differenzielle Signalpfad *ZFₒᵤₜ* A - *ZFₒᵤₜ* B bzw. der Gegentakt-Ausgang des Mischers 18 ist ständig niederohmig. Der Vorteil eines differenziellen Signalpfades *ZFₒᵤₜ* A - *ZFₒᵤₜ* B mit zwei Einzelpfaden *ZFₒᵤₜ* A, *ZFₒᵤₜ* B ist insbesondere bei langen Leitungen in der hohen Störsicherheit zu sehen. Ein weiterer Vorteil des differentiellen Signalpfades *ZFₒᵤₜ* A *- ZFₒᵤₜ* B am Ausgang des Mischers 18 liegt darin, dass eventuell auftretende Temperaturdriften kompensiert werden.

In jedem der beiden Einzelsignalpfade *ZFₒᵤₜ* A, *ZFₒᵤₜ* B des differentiellen Signalpfades *ZFₒᵤₜ* A - *ZFₒᵤₜ* B ist jeweils ein steuerbares Schaltelement 24a, 24b vorgesehen, das zwischen zwei Schalterstellungen X, Y hin- und hergeschaltet werden kann. Bei den Schaltelementen 24a, 24b handelt es sich beispielsweise um CMOS Transistoren. Derartige Schaltelemente sind als integrierte Schaltungen in jeder gewünschten Konfiguration realisierbar.

In Reihe zu den beiden Schaltelementen 24a, 24b ist ein erstes Speicherelement 25 geschaltet. Bei dem Speicherelement handelt es sich um einen Kondensator. Die Betätigung der Schaltelemente 24a, 24b erfolgt über den Oszillator 23. Während der Aktivphase des Oszillators 23 sind die Schaltelemente 24a, 24b in der Schalterstellung X, X angeordnet, und das Speicherelement 25 wird auf den Signalpegel des differentiellen Signalpfades *ZFₒᵤₜ* A *- ZFₒᵤₜ* B aufgeladen. Nach Umschaltung auf die Schalterstellungen Y, Y wird der untere Schalter 24a und damit der untere Pol des Kondensators 25 auf Bezugspotential GND gelegt. Der obere Schalter 24b wird auf den zweiten Kondensator 26 umgeladen. Somit übernimmt der zweite Kondensator 26 die Ladung des ersten Kondensators 25. Der zweite Kondensator 26 hat die Aufgabe, die Ladung solange zu speichern, bis ein neuer Schaltzyklus eingeleitet wird. Vom Kondensator 26 wird die Ladung anschließend über den auf Bezugspotential GND geschalteten Signalpfad *S*_{sin*gle*} an den Verstärker 29 weitergeleitet. Der Verstärker 29 ist in Fig. 3 durch den Transistor 28 und den Widerstand 27 angedeutet.

Bei der Ausgestaltung der erfindungsgemäßen Schaltungsanordnung 12 mit zwei Kondensatoren 25, 26 spielen deren Kapazitätswerte eine Rolle. Die Kapazitätswerte müssen auf den jeweiligen Anwendungsfall abgestimmt sein. Da der Schaltzustand X, X sehr kurz ist, hat der erste Kondensator 25 nur wenige pF, damit er schnell geladen werden kann. Der Kapazitätswert des zweiten Kondensators 26 hängt hauptsächlich davon ab, mit wie vielen Schaltzyklen das umgetastete Signal seinen vollen Pegel erreichen soll. Je langsamer dies geschehen darf - je geringer also die Messrate ist - um so größer kann der Kapazitätswert des zweiten Kondensators 26 gewählt werden.

Wie bereits anhand der im Anspruch 1 beschriebenen erfindungsgemäßen Lösung dargelegt, kann der zweite Kondensator 26 durchaus auch entfallen. Dies ist möglich, da das Tastverhältnis der Schalterstellungen X, X zu den Schalterstellungen Y, Y sehr extrem ist. Das Tastverhältnis liegt beispielsweise bei 1 : 500. Generell gesprochen, besteht hier ein Unterschied von mindestens zwei Größenordnungen. Bezogen auf den vorhergehenden konkreten Fall bedeutet dies, dass der Schaltfall X, X für 1 ns ansteht. Während dieser Zeit liegt an der Folgeelektronik kein Signal an.

Hingegen verbleiben die Schaltelemente 24a, 24b im konkreten Fall für 500 ns in der Schalterstellung Y, Y. In dieser verhältnismäßig langen Zeit übernimmt der erste Kondensator 25 auch die Aufgabe des zweiten Kondensators 26, da beide während des gesamten Zeitraums parallel geschaltet sind. Für den kurzen Zeitraum der Schalterstellungen X, X lässt sich das Tiefpassverhalten der Folgeelektronik dazu nutzen, die kurze Unterbrechung des Signals auszuintegrieren.

Möglich bzw. denkbar ist auch noch ein dritter Schaltfall Z, Z, bei dem der erste Kondensator 25 weder mit dem Ausgang des Mischers 18 noch mit dem zweiten Kondensator 26 verbunden ist. Dann hängt der erste Kondensator 25 quasi in der Luft. In diesem Fall ist der zweite Kondensator 26 wiederum erforderlich, um das Signal zwischenzeitlich zu speichern. Die Dauer des Verweilens in der Schalterstellung Z, Z kann dazu genutzt werden, parasitäre Effekte zu minimieren.

Bleibt zu erwähnen, dass die Trennlinie in Fig. 3 andeutet, welche Komponenten beispielsweise auf einem Halbleiterchip und welche außerhalb des Halbleiterchips angeordnet sein können.

### Bezugszeichenliste

- 1: Pulsradargerät
- 2: Füllgut
- 3: Oberfläche des Füllguts
- 4: Behälter
- 5: Deckel
- 6: Öffnung
- 7: Antenne
- 8: Signalerzeugungseinheit
- 9: Einkoppeleinheit
- 10: Empfangs-/Auswerteschaltung
- 11: Sende-/Empfangsweiche
- 12: erfindungsgemäße Schaltungsordnung
- 13: Mikrocontroller
- 14: Sendetaktgenerator
- 15: Sendepulsgenerator
- 16: Pulsformer
- 17: Sendeoszillator
- 18: Mischer
- 19: Abtasttaktgenerator
- 20: Pulsformer
- 21: Oszillator
- 22: Abtastpulsgenerator
- 23: Steuerpulsgenerator
- 24a: Schaltelement
- 24b: Schaltelement
- 25: erstes Speicherelement
- 26: zweites Speicherelement
- 27: Widerstand
- 28: Transistor
- 29: Verstärker

- Tx: Sendepulse
- Rx: Echopulse
- CLKs: Sendetakt
- fs: Sendetaktfrequenz
- CLKa: Abtasttakt
- fa: Abtasttaktfrequenz
- Sa: Abtastpuls
- S: Steuerpuls
- ZF: Zwischenfrequenzsignal
- *ZFₒᵤₜ* A: Einzelsignalpfad
- *ZFₒᵤₜ* B: Einzelsignalpfad
- *ZFₒᵤₜ* A - *ZFₒᵤₜ* B: differentieller Signalpfad
- *S*_{sin *gle*}: Signalpfad gegen Bezugspotential geschaltet
- GND: Bezugspotential

## Patentansprüche

1. Schaltungsanordnung zur Umsetzung von einem differenziellen Signalpfad (*ZFₒᵤₜ* A - *ZFₒᵤₜ* B) am Ausgang eines der Schaltungsanordnung zugehörigen Mischers (18) auf einen gegen Bezugspotential (GND) geschalteten Signalpfad (*S*_{sin*gle*}),
- wobei in jedem der beiden Einzelsignalpfade (*ZFₒᵤₜ* A, *ZFₒᵤₜ* B) des differentiellen Signalpfades (ZF*ₒᵤₜ* A - *ZFₒᵤₜ* B) jeweils ein steuerbares Schaltelement (24a, 24b) vorgesehen ist,
- wobei in Reihe zu den beiden Schaltelementen (24a, 24b) ein erstes Speicherelement (25) geschaltet ist,
- wobei zumindest eine Steuerung (23) für die beiden Schaltelemente (24a, 24b) vorgesehen ist, die während einer Aufladphase des ersten Speicherelements (25) den differentiellen Signalpfad (*ZFₒᵤₜ* A, *ZFₒᵤₜ* B) am Ausgang des Mischers (18) mit dem ersten Speicherelement (25) verbindet, und das am differentiellen Ausgang des Mischers (18) anliegende Ausgangssignal auf das erste Speicherelement (25) lädt, und die während der Entlade- bzw. Umladephase das erste Speicherelement (25) mit dem gegen das Bezugspotential (GND) geschalteten Signalpfad verbindet, so dass die im ersten Speicherelement (25) gespeicherte Ladung über den gegen das Bezugspotential (GND) geschalteten Signalpfad umgeladen wird.

2. Schaltungsanordnung nach Anspruch 1,
wobei parallel zu dem ersten Speicherelement (25) ein zweites Speicherelement (26) vorgesehen ist, das mit einem Ausgang gegen das Bezugspotential (GND) geschaltet ist, so dass während der Entlade- bzw. Umladephase die im ersten Speicherelement (25) gespeicherte Ladung auf das zweite Speicherelement (26) umgeladen wird.

3. Schaltungsanordnung nach Anspruch 1 oder 2,
wobei der Mischer (18) mit dem differenziellen Signalpfad, die beiden Schaltelemente und das erste Speicherelement auf einem Halbleiter-Chip angeordnet sind.

4. Schaltungsanordnung nach Anspruch 1 oder 2,
wobei der Mischer (18) mit dem differenziellen Signalpfad (*ZFₒᵤₜ* A, *ZFₒᵤₜ* B) auf einem Halbleiter-Chip angeordnet ist.

5. Schaltungsanordnung nach zumindest einem der Ansprüche 1-4,
wobei es sich bei dem Bezugspotential (GND) um das Massepotential handelt.

6. Schaltungsanordnung nach einem oder mehreren der vorhergehenden Ansprüche,
wobei es sich bei den Speicherelementen (25, 26) um Kondensatoren handelt.

7. Pulsradargerät (1) zur Bestimmung oder Überwachung des Füllstands (F) eines Füllguts (2) in einem Behälter (4)
- mit einem Sendetaktgenerator (14) zum Erzeugen eines Sendetakts (CLKs) mit einer vorgegebenen Sendetaktfrequenz (fs),
- mit einem Sendepulsgenerator (15), der von dem Sendetakt (CLKs) getriggert wird, um Sendepulse (Tx) mit der Sendetaktfrequenz (fs) an eine Antenne (7) weiterzuleiten,
- wobei die Antenne (7) die Sendepulse (Tx) in Richtung der Oberfläche (3) des Füllguts (2) abstrahlt und die an der Oberfläche (3) des Füllguts (2) reflektierten Echosignale (Rx) empfängt,
- mit einem Abtasttaktgenerator (19) zum Erzeugen eines Abtasttakts (CLKa) mit einer vorgegebenen Abtasttaktfrequenz (fa), die sich geringfügig von der Sendetaktfrequenz (fs) unterscheidet,
- mit einem Abtastpulsgenerator (22), der von dem Abtasttakt (CLKa) getriggert wird, um Abtastpulse (Sa) mit der Abtasttaktfrequenz (fa) zu erzeugen,
- mit einem Mischer (18) zum Erzeugen eines Zwischenfrequenzsignals (ZF) durch Mischen der Echopulse (Rx) mit den Sendepulsen (Sx),
- mit einem Integrierglied (12) zur Integration des Zwischenfrequenzsignals (ZF), wobei das Integrierglied (12) die in zumindest einem der Ansprüche 1-4 beschriebene Schaltungsanordnung zur Umsetzung von zwei differenziellen Signalpfaden (*ZFₒᵤₜ* A, *ZFₒᵤₜ* B) am Ausgang des Mischers (18) auf einen gegen Bezugspotential (GND) geschalteten Signalpfad umfasst.

8. Pulsradargerät nach Anspruch 7,
wobei die Steuerung (23) und die beiden Schaltelemente (24a, 24b) so ausgelegt sind, dass das Zwischenfrequenzsignal (ZF) mit der Abtasttaktfrequenz (fa) abgetastet wird.

9. Pulsradargerät nach Anspruch 7 oder 8,
wobei die Steuerung (23) so ausgelegt ist, dass sie die beiden Schaltelemente (24a, 24b) simultan steuert.

10. Pulsradargerät nach Anspruch 7 oder 8,
wobei zwei separate Steuerungen vorgesehen sind, die die beiden Schaltelemente (24a, 24b) simultan steuern.

## Claims

1. Circuit arrangement to convert a differential signal path (ZFₒᵤₜ A - ZFₒᵤₜ B) at the output of a mixer (18) pertaining to the circuit arrangement to a signal path (S_{single}) switched against the reference potential (GND),
- wherein a controllable switching element (24a, 24b) is provided in each of the two individual signal paths (ZFₒᵤₜ A, ZFₒᵤₜ B) of the differential signal path (ZFₒᵤₜ A
- ZFₒᵤₜ B),
- wherein a first storage element (25) is switched in series to the two switching elements (24a, 24b),
- wherein at least one control system (23) is provided for the two switching elements (24a, 24b) which connects the differential signal path (ZFₒᵤₜ A, ZFₒᵤₜ B) at the output of the mixer (18) to the first storage element (25) during a charging phase of the first storage element (25), and transfers the output signal, which is present at the differential output of the mixer (18), onto the first storage element (25), and which connects the first storage element (25) to the signal path switched against the reference potential (GND) during the discharging or charge transfer phase, so that the charge stored in the first storage element (25) is transferred via the signal path switched against the reference potential (GND).

2. Circuit arrangement as claimed in Claim 1,
wherein in parallel to the first storage element (25) a second storage element (26) is also provided which is switched against the reference potential (GND) with one output such that during the discharge or charge transfer phase the charge saved in the first storage element (25) is transferred to the second storage element (26).

3. Circuit arrangement as claimed in Claim 1 or 2,
wherein the mixer (18) with the differential signal path, the two switching elements and the first storage element are arranged on a semi-conductor chip.

4. Circuit arrangement as claimed in Claim 1 or 2,
wherein the mixer (18) with the differential signal path (ZFₒᵤₜ A, ZFₒᵤₜ B) is arranged on a semi-conductor chip.

5. Circuit arrangement as claimed in at least one of the Claims 1 to 4,
wherein the reference potential (GND) is the ground potential.

6. Circuit arrangement as claimed in one or more of the previous claims,
wherein the storage elements (25, 26) are capacitors.

7. Pulse radar device (1) for determining or monitoring the level (F) of a product (2) in a vessel (4)
- with a transmit clock generator (14) designed to generate a transmit clock (CLKs) with a predefined transmit clock frequency (fs),
- with a transmit pulse generator (15), which is triggered by the transmit clock (CLKs) to forward transmit pulses (Tx) to an antenna (7) at the transmit clock frequency (fs),
- wherein the antenna (7) emits the transmit pulses (Tx) in the direction of the surface (3) of the product (2) and receives the echo signals (Rx) reflected at the surface (3) of the product (2),
- with a sampling clock generator (19) designed to generate a sampling clock (CLKa) at a predefined sampling clock frequency (fa), which differs marginally from the transmit clock frequency (fs),
- with a sampling pulse generator (22), which is triggered by the sampling clock (CLKa), to generate sampling pulses (Sa) at the sampling clock frequency (fa),
- with a mixer (18) to generate an intermediate frequency signal (ZF) by mixing the echo pulses (Rx) with the transmit pulses (Sx),
- with an integrator circuit (12) designed to integrate the intermediate frequency signal (ZF), wherein the integrator circuit (12) comprises the circuit arrangement described in at least one of the Claims 1 to 4, designed to convert two differential signal paths (ZFₒᵤₜ A, ZFₒᵤₜ B) at the output of the mixer (18) to a signal path switched against the reference potential (GND).

8. Pulse radar device as claimed in Claim 7,
wherein the control system (23) and the two switching elements (24a, 24b) are designed in such a way that the intermediate frequency signal (ZF) is sampled at the sampling clock frequency (fa).

9. Pulse radar device as claimed in Claim 7 or 8,
wherein the control system (23) is designed in such a way that it controls the two switching elements (24a, 24b) simultaneously.

10. Pulse radar device as claimed in Claim 7 or 8,
wherein two separate control systems are provided which control the two switching elements (24a, 24b) simultaneously.

## Revendications

1. Circuit destiné à la conversion d'un chemin de signal différentiel (ZFₒᵤₜ A - ZFₒᵤₜ B) à la sortie d'un mélangeur (18) appartenant au circuit, en un chemin de signal (S_{single}) commuté par rapport à un potentiel de référence (GND),
- pour lequel dans chacun des deux chemins de signal individuels (ZFₒᵤₜ A, ZFₒᵤₜ B) du chemin de signal différentiel (ZFₒᵤₜ A - ZFₒᵤₜ B) est prévu un élément de commande (24a, 24b) contrôlable,
- pour lequel est couplé en série avec les deux éléments de commande (24a, 24b) un premier élément de stockage (25),
- pour lequel est prévu au moins un système de commande (23) pour les deux éléments de commande (24a, 24b) qui, pendant une phase de recharge du premier élément de stockage (25), relie le chemin de signal différentiel (ZFₒᵤₜ A, ZFₒᵤₜ B) à la sortie du mélangeur (18) avec le premier élément de stockage (25) et charge le signal de sortie appliqué à la sortie différentielle du mélangeur (18) sur le premier élément de stockage (25), et qui pendant la phase de décharge et de transfert relie le premier élément de stockage (25) avec le chemin de signal commuté par rapport au potentiel de référence (GND), de telle sorte que la charge stockée dans le premier élément de stockage (25) est transférée via le chemin de signal commuté par rapport au potentiel de référence (GND).

2. Circuit selon la revendication 1,
pour lequel est prévu, parallèlement au premier élément de stockage (25), un deuxième élément de stockage (26), qui est commuté avec une sortie par rapport au potentiel de référence (GND), si bien que pendant la phase de décharge et de transfert, la charge accumulée dans le premier élément de stockage (25) est transférée vers le deuxième élément de stockage (26).

3. Circuit selon la revendication 1 ou 2,
pour lequel le mélangeur (18) avec le chemin de signal différentiel, les deux éléments de commande et le premier élément de stockage sont disposés sur une puce de semi-conducteur.

4. Circuit selon la revendication 1 ou 2,
pour lequel le mélangeur (18) avec le chemin de signal différentiel (ZFₒᵤₜ A, ZFₒᵤₜ B) est disposé sur une puce de semi-conducteur.

5. Circuit selon au moins l'une des revendications 1 à 4,
pour lequel il s'agit, concernant le potentiel de référence (GND), du potentiel de masse.

6. Circuit selon l'une ou plusieurs des revendications précédentes,
pour lequel il s'agit, concernant les éléments de stockage (25, 26), de condensateurs.

7. Appareil radar à impulsions (1) destiné à la détermination ou la surveillance du niveau (F) d'un produit (2) dans un réservoir (4)
- avec un générateur d'horloge d'émission (14) destiné à générer une impulsion d'émission (CLKs) à une fréquence d'impulsions d'émission (fs) prédéfinie,
- avec un générateur d'impulsions d'émission (15), qui est déclenché par l'impulsion d'émission (CLKs), afin de transmettre les impulsions d'émission (Tx) à la fréquence d'impulsions d'émission (fs) à une antenne (7),
- pour lequel l'antenne (7) émet les impulsions d'émission (Tx) en direction de la surface (3) du produit (2) et reçoit les signaux d'écho (Rx) réfléchis à la surface (3) du produit (2),
- avec un générateur d'horloge d'échantillonnage (19) destiné à la génération d'une impulsion d'échantillonnage (CLKa) à une fréquence d'horloge d'échantillonnage (fa) prédéfinie, qui se distingue légèrement de la fréquence d'horloge d'émission (fs),
- avec un générateur d'impulsions d'échantillonnage (22), qui est déclenché par l'impulsion d'échantillonnage (CLKa), afin de générer les impulsions d'échantillonnage (Sa) à la fréquence d'horloge d'échantillonnage (fa),
- avec un mélangeur (18) destiné à la génération d'un signal de fréquence intermédiaire (ZF) par le mélange des impulsions d'écho (Rx) avec les impulsions d'émission (Sx),
- avec un circuit intégrateur (12) destiné à l'intégration du signal de fréquence intermédiaire (ZF), le circuit intégrateur (12) comprenant le circuit décrit dans au moins l'une des revendications 1 à 4, destiné à la conversion de deux chemins de signal différentiels (ZFₒᵤₜ A, ZFₒᵤₜ B) à la sortie du mélangeur (18) en un chemin de signal commuté par rapport au potentiel de référence (GND).

8. Appareil radar à impulsions selon la revendication 7,
pour lequel le système de commande (23) et les deux éléments de commande (24a, 24b) sont conçus de telle sorte que le signal de fréquence intermédiaire (ZF) est échantillonné à la fréquence d'horloge d'échantillonnage (fa).

9. Appareil radar à impulsions selon la revendication 7 ou 8,
pour lequel le système de commande (23) est conçue de telle sorte que les deux éléments de commande (24a, 24b) sont pilotés simultanément.

10. Appareil radar à impulsions selon la revendication 7 ou 8,
pour lequel sont prévus deux systèmes de commande séparés, qui pilotent simultanément les deux éléments de commande (24a, 24b).
